# EUROPEAN PATENT SPECIFICATION

(11) **EP 0 394 057 B1**
(45) Date of publication and mention of the grant of the patent: **08.01.1997**
(21) Application number: 90304244.8
(22) Date of filing: 20.04.1990
(51) Int. Cl.: H03K 17/94, H03K 17/968

(54) **Method and apparatus for preventing erroneous operation in non-contact push-button switch**
Verfahren und Einrichtung zum Verhindern eines Fehlbetriebs bei kontaktlosen Druckknopfschaltern
Méthode et dispositif pour prévenir un fonctionnement erroné d'un interrupteur à bouton-poussoir sans contact

(30) Priority: 21.04.1989 JP 101992/89; 15.05.1989 JP 121162/89
(43) Date of publication of application: 24.10.1990
(73) Proprietor: SHINKOH ELECTRIC CO., LTD., Higashisumiyo shi-ku, Osaka (JP)
(72) Inventor: Umemura, Heihachiro, Sakai, Osaka Pref. (JP); Shibata, Michio, Hirakata, Osaka Pref. (JP)
(74) Representative: Boydell, John Christopher

(56) References cited:
- DE-A- 2 530 000
- DE-A- 2 653 365
- DE-B- 2 848 103
- JP-A-61 253 727
- PATENT ABSTRACTS OF JAPAN vol. 11, no. 152 (E-507)(2599), 16 May 1987; & JP - A - 61288619 (SHINKO DENKI K.K.) 18.12.1986
- PATENT ABSTRACTS OF JAPAN vol. 13, no. 561 (E-859)(3909), 13 December 1989; && JP - A - 1233912 (TOKYO DENSHI KOGYO K.K.) 19.09.1989
- PATENT ABSTRACTS OF JAPAN vol. 9, no. 65 (E-304)(1788), 26 March 1985; & JP - A - 59202733 (SHINKOU DENKI K.K.) 16.11.1984
- PATENT ABSTRACTS OF JAPAN vol. 7, no. 253 (P-235)(1398), 10 November 1983; & JP - A - 58137783 (TOUKIYOU SEIMITSU K.K.) 16.08.1983

## Description

This invention relates to a method and an apparatus for preventing erroneous operation in non-contact push-button switch which is used as pendant switch of hoist crane, for example.

Generally, as the pendant switch mentioned above, a push-button switch of contact type has been used. However, in operating the push-button switch of this type, sparking takes place at each operation with the result that a contact consumes and the service life of a switch is shortened. Also, in the low-voltage operation, inferior contact takes place and the crane operation lacks accuracy. Moreover, in the case of a multi-stage operation switch of contact system, the switch proper must be made large.

In view of the above demerits of the push-button switch of contact type, the present inventors previously suggested a push-button switch of non-contact type which utilizes light (Japanese Patent Application No.58-77860 and Japanese Patent Application No.60-94294). This switch comprises a luminous element, a light receiving element and a push-button having a light shading plate provided between both elements and is so designed that projection to the light receiving element is selected according to the pushed down position of the push-button.

Since the above pendant switch is suspended from a hoist crane, it is easier to be subject to impact, vibration, etc., than the control box, namely, it is under severe conditions. Therefore, electronic parts of the push-button switch are easier to break than the electronic parts in the control box. When the switch breaks, if an operation signal is not given in spite of the operation of the push-button, there is no fear of unreasonable working but if an operation signal is given continuously in spite of restoring of the push-button to OFF, unreasonable working of the crane or the like will result. This is very dangerous.

DE-B-2 848 103 discloses a non-contact push-button switch for use in a car having a light receiving element, a light emitting element and a push-button provided with a light shading plate which is interposed between both elements. The light emitting member is powered by a first pulse power signal generated by a pulse power source and thus emits light pulses. The pulse power source also produces a second pulse power signal which is input to a flip-flop as the clock signal. The output signal from the light receiving element is input to the flip-flop as the data input. The pulse power signals are such that when the switch is operating correctly the flip-flop produces a continuous output signal which is synchronised with the ON-OFF of the push-button.

Patent Abstracts of Japan, vol. 11, No. 152 (E-507) (2599), 16 May 1987; and JP-A-61288619 (SHINKO DENKI K.K.) 18.12.1986 discloses a push-button assembly consisting of two switch circuits each consisting of a light emitting element, a photodetecting element and a light shield plate inserted between the two elements. The arrangement is such that the light from the light emitting element is projected onto the photodetecting element only when the push-button is depressed.

### SUMMARY OF THE INVENTION

The present invention has been made in view of the above.

There is a need to prevent erroneous operation which takes place when a push-button is in mechanical trouble, namely, a push-button does not return to the original position due to damage of the spring for returning the push-button or due to biting of foreign matters.

According to the present invention there is provided a push-button switch assembly including: a push-button having a spring for restoring the switch to its initial, non-pushed state and a light shading means with a light transmitting window, the push-button being slidably located in a block; a light emitting element; and a light receiving element; the light shading means being located between the light emitting element and the light receiving element in such a way that when the push button is pushed, the light of the light emitting element is cast on the light receiving element, the assembly being characterised by an auxiliary button which is built into the push-button, the auxiliary button being provided with an associated auxiliary light shading means and an associated spring for biasing the auxiliary button away from the push button, the arrangement being such that when the push-button functions normally the light transmitted from the light emitting element is not inhibited by the auxiliary button and the associated auxiliary light shading means, whereby in the case of a mechanical failure of the spring for restoring the switch to its initial, non-pushed state, the auxiliary button is moved by the associated spring away from the push button, which in turn causes the auxiliary light shading means to move between the light emitting element and the light receiving element such that an unwanted pushed ON state of the switch due to mechanical failure is avoided.

A method of preventing erroneous operation of non-contact push-button switch is to impress pulse electric power on a non-contact switch, to discriminate good or bad of the output signal from the switch by comparing it with the waveform of the impressed pulse electric power at a discrimination circuit and to select and give an operation signal to a driving circuit of an inverter, an electromagnetic contactor or the like.

Even if an operation output is given from the switch, while the push-button is in OFF state due to trouble of electronic parts constituting a non-contact push-button, no signal which means operation is given from the discrimination circuit and accordingly the OFF state is maintained and unreasonable working of the apparatus or other trouble does not take place.

Preferably the erroneous operation preventive apparatus for a non-contact type push-button switch according to the present invention is to divide the push-button into a push-button proper and an auxiliary button, to insert the auxiliary button into the push-button proper, with a spring for returning the auxiliary button interposed therebetween, to have light pass through by making a light transmitting window of a light shading plate and a light transmitting window of an auxiliary light shading plate coincide with each other while the push-button is working normally and when the auxiliary button separates from the push-button proper due to spring pressure, the light transmitting window of the light shading plate is blocked by the auxiliary light shading plate for shading the light.

Preferably when the pushed down push-button proper does not return to the original position due to damage of the spring for returning or other reason, only the auxiliary button returns and projection is intercepted by the auxiliary shading plate. Thus a switch-off state is obtained.

### BRIEF DESCRIPTION OF THE DRAWINGS

Features of the present invention will be understood more clearly from the following description made with reference to the accompanying drawings, in which:
Figures 1-11 relate to possible ways for possible circuitries to prevent erroneous operation of electronic parts, in which:
   Figure 1 is an explanation drawing of the principle;
   Figure 2 is an explanation drawing of pulse signals;
   Figure 3 is an explanation drawing of the gist of discrimination by a discrimination circuit;
   Figure 4 is an explanation drawing of the gist of operation of a discrimination circuit and a synchronous signal conversion circuit;
   Figure 5 is an explanation drawing of a modified pulse signal;
   Figure 6 is a circuit diagram of a non-contact push-button switch;
   Figure 7 is an explanation drawing of the perspective of the non-contact push-button switch;
   Figure 8 is a circuit diagram of a non-contact push-button switch;
   Figure 9 is an explanation drawing of the perspective of the non-contact push-button switch;
   Figure 10 is a circuit diagram of a non-contact push-button switch;
   Figure 11 is an explanation drawing of the perspective of the non-contact push-button switch;
Figures 12 to 19 relate to the prevention of mechanical erroneous operation, in which:

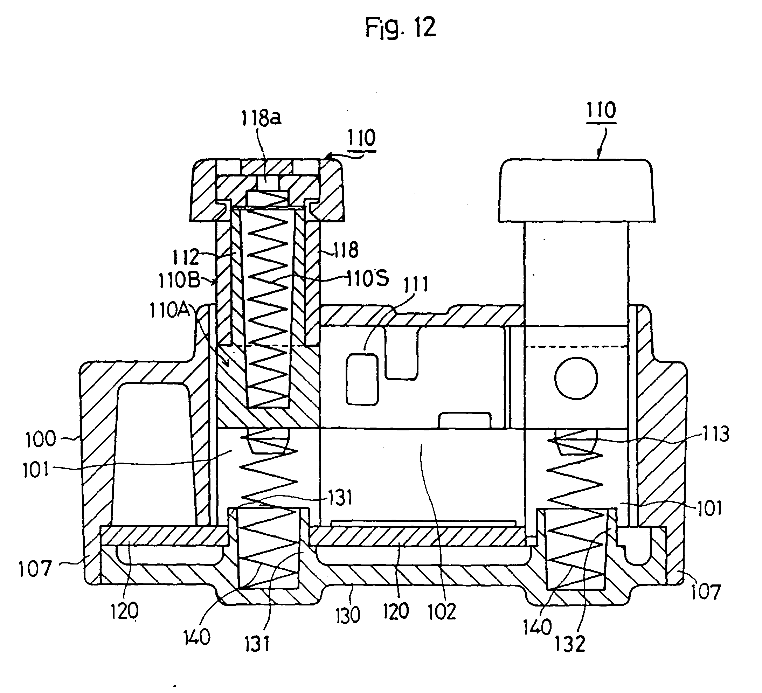

   Figure 12 is a cross section;

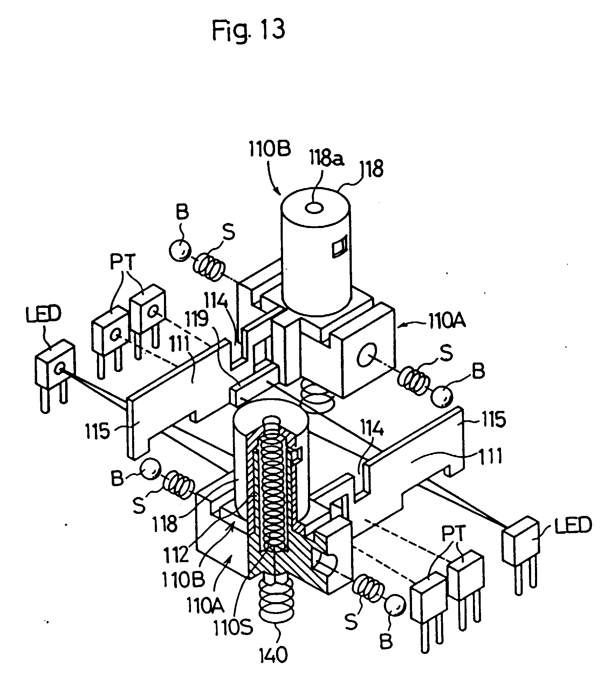

   Figure 13 is an explanation drawing of switch operation by the push-button;

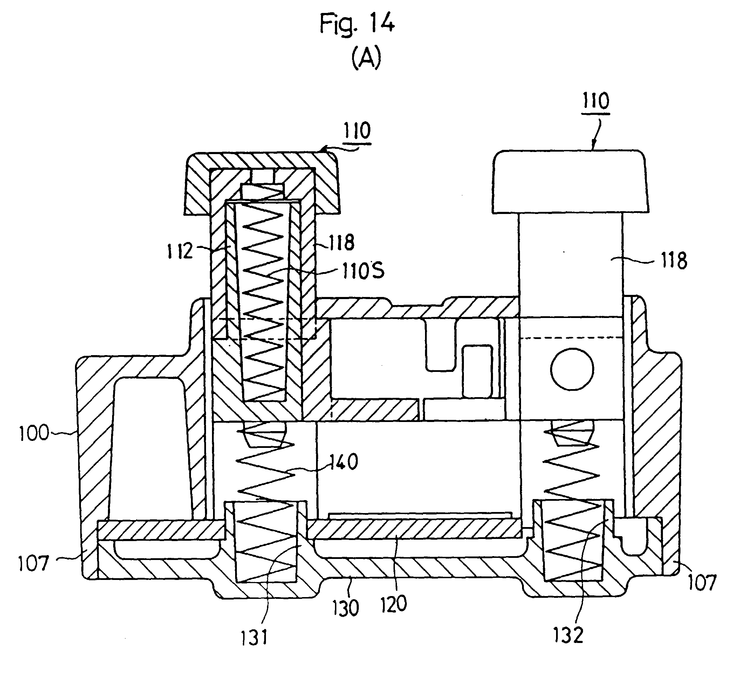

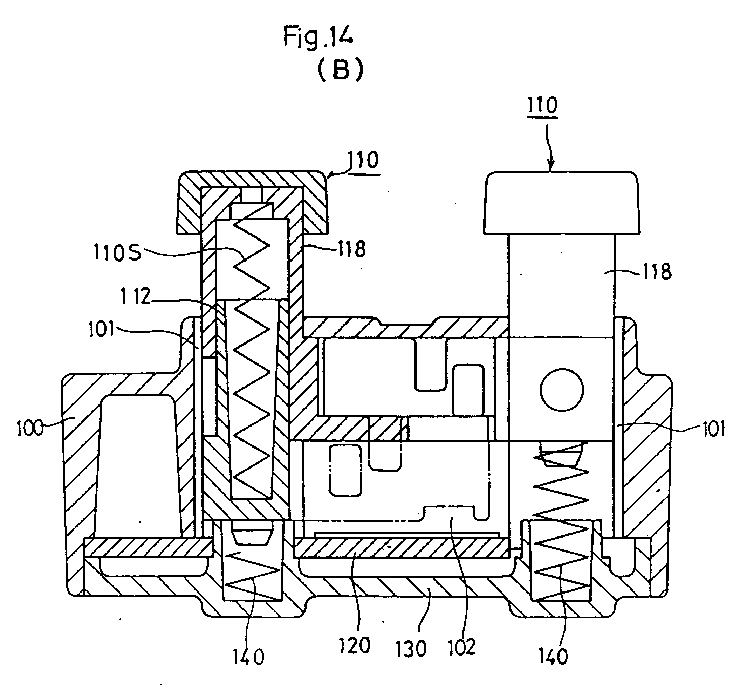

   Figure 14 is a front view in vertical section;

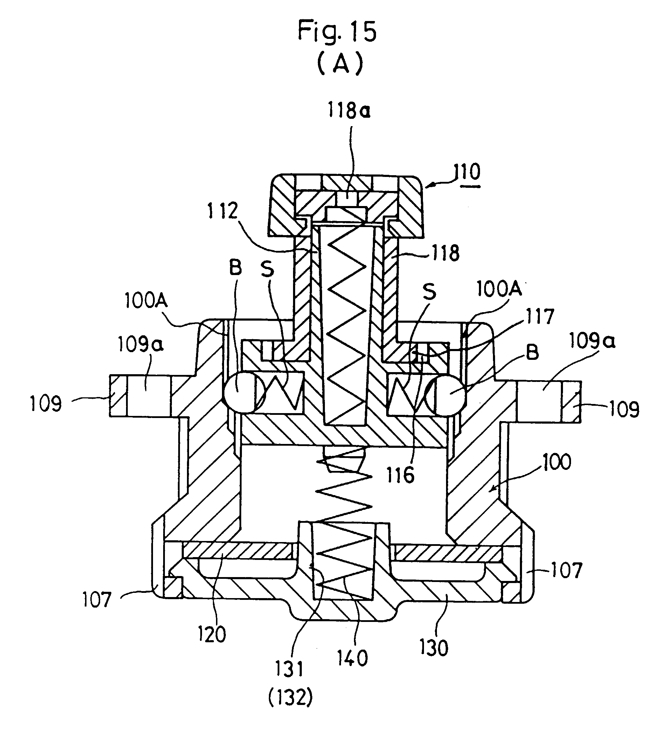

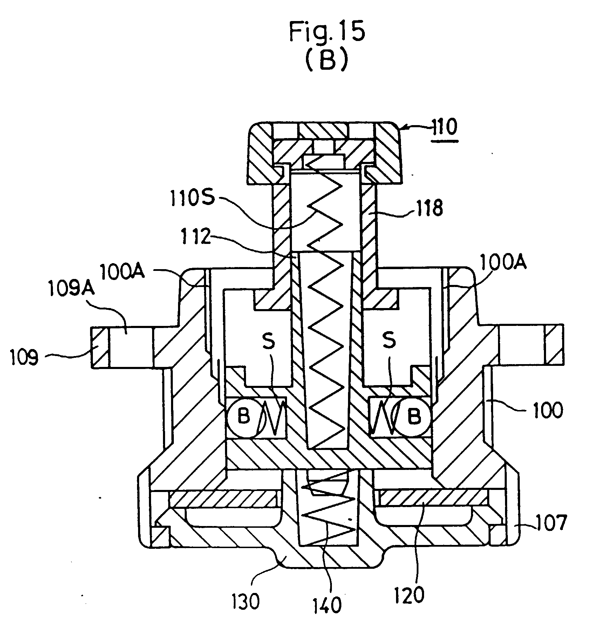

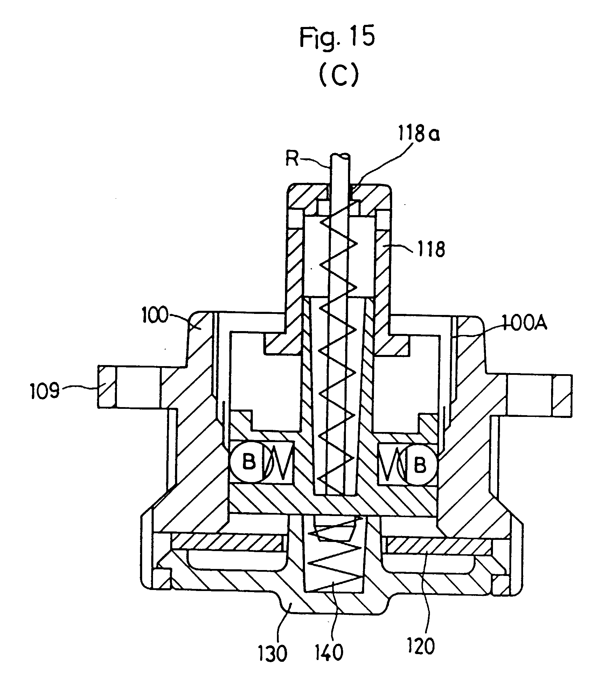

   Figure 15 is a side view in vertical section;

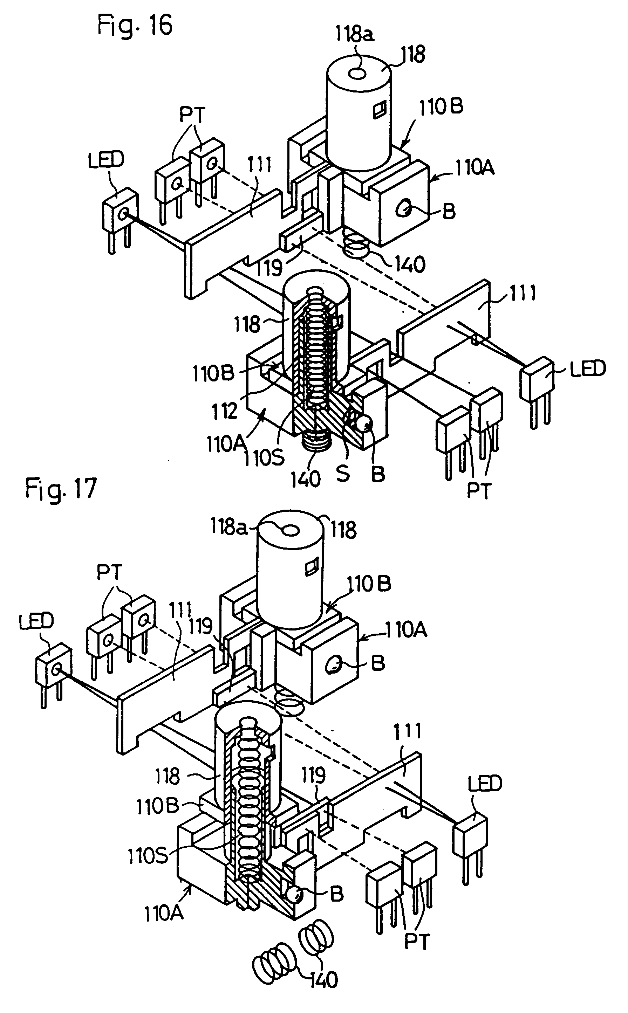

   Figure 16 is an explanation drawing at the time of ON operation of the safety device;
   Figure 17 is an explanation drawing at the time of trouble -

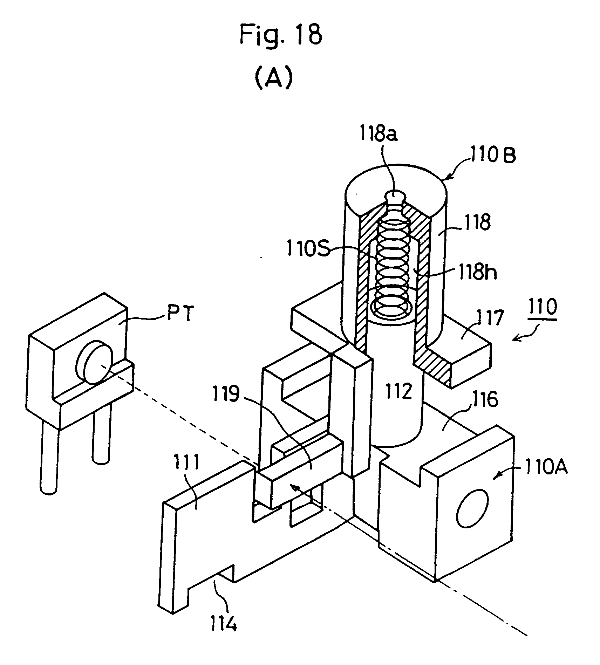

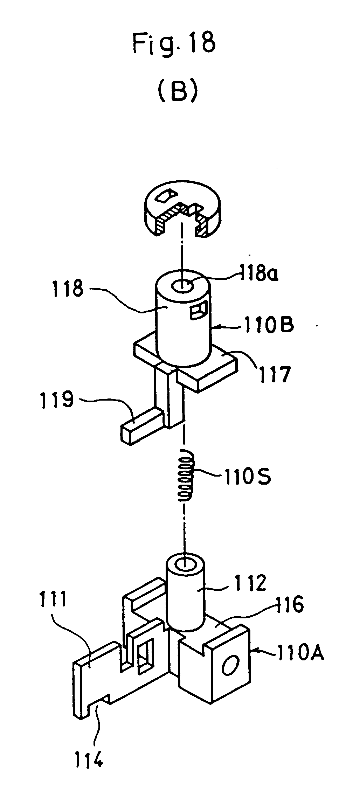

   Figure 18 is a perspective view of the push-button, partly broken down; and

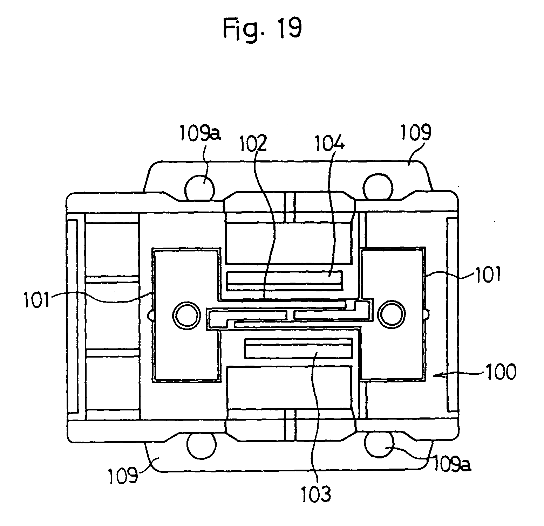

   Figure 19 is a bottom view of a block proper, from which a back plate and a base plate are removed.

### DETAILED DESCRIPTION OF THE INVENTION

### Embodiment

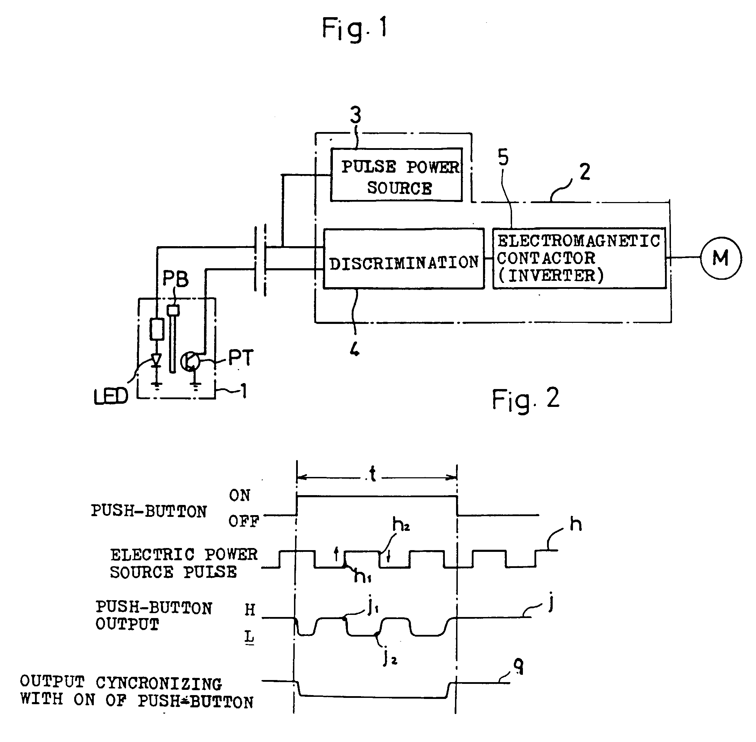

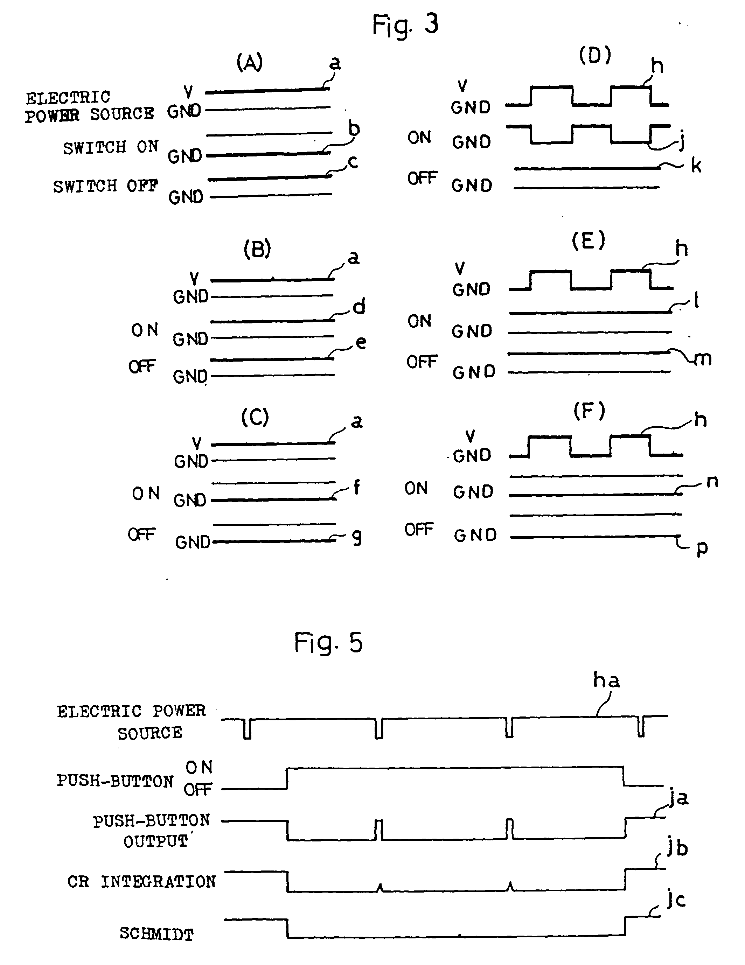

Figures 1 to 11 show possible circuitries that prevent erroneous operation of the electronic parts. Figure 3 is an explanation drawing of the gist of a currently preferred method of detection of erroneous operation and shows the relation between the impressed electric power source and the switch output signal (pull up of a phototransistor for output by resistance) by using a luminous body and a light receiving body for a non-contact push-button switch. In this figure, (A), (B) and (C) show the case where electric power source is direct current;(D), (E) and (F) show the case of pulse electric power source.

Fig. 3 (A) shows the case where the push-button switch works normally, namely, when impressed electric power a is high level (hereinafter referred to as H level), output signal b in the case of switch ON is low level (hereinafter referred to as L level) and in the case of switch OFF, output signal c is H level. GND shows the L level position.

Fig. 3 (B) shows the case where a luminous element does not emit light or where a light receiving element does not work. In this case, irrespective of whether the switch is ON or OFF, output signals d, e are H level.

Fig. 3 (C) shows the case where a light receiving element is in operative state, although the push-button is out of order and is in OFF state. In this case, output signals f and g are L level, irrespective of whether the switch is ON or OFF. Therefore, switch ON state in a normal case (Fig. 3 (A) ) is presented and discrimination is impossible. There is a fear that the apparatus may work unreasonably.

Fig. 3 (D) shows the case where pulse electric power source is impressed and the push-button works normally. In this case, output signal j in the case of switch ON is a pulse signal of reverse phase to the impressed pulse electric power h and output signal k in the case of switch OFF is H level.

Fig. 3 (E) shows the case where a luminous element does not emit light or a light receiving element does not work, similarly to Fig. 3 (B). In this case, output signals l amd m are H level, irrespective of whether the switch is ON or OFF.

Fig. 3 (F) shows that a light receiving element is in a working state, although the push-button switch is in OFF state. In this case, output signals n and p of the switch are L level, irrespective of whether the switch is ON or OFF.

Fig. 1 is a rough explanation drawing of prevention of erroneous operation by impressing pulse electric power onto the push-button switch and shows an example of non-contact push-button switch 1 comprising a luminous element LED and a light receiving element PT (photo-transistor, CD cell, photo-diode or the like) which are opposite to each other, with a push-button PB therebetween. The push-button normally (in OFF position) intersects projection from the luminous element LED and only when the push-button is pressed (ON), it allows projection to the light receiving element PT.

A control box 2 which is an erroneous operation preventive apparatus for the non-contact push-button switch 1, is provided with a pulse electric power source 3 and a discriminating circuit 4.

The pulse electric power source 3 impresses pulse electric power on the luminous element LED, which carries out the corresponding pulse radiation. Therefore, by pushing the push-button PB (ON), projection onto the light receiving element is maintained during the pressing time t and the output signal j of the push-button switch is issued as pulse signal of reversed phase.

The output signal j is impressed on the discrimination circuit 4. A pulse voltage is also impressed on the discrimination circuit 4 from the electric power source 3 and the output signals are compared on the basis of such pulse voltage, namely, the output signals (ON, OFF output signals) of the push-button switch of (D), (E) and (F) in Fig. 3 are compared. More particularly, if output signals of the push-button switch of (D), (E) and (F) in Fig. 3 are compared, in the case of (D) and (E), output of the push-button switch is H level (a light receiving element does not work) when the electric power source is L level (a luminous element does not emit light), irrespective of whether the push-button is ON or OFF.

In consideration of the delay in the response of the light receiving element PT to the light, if the point j₁ of the output signal j of the push-button switch which corresponds to the electric power source pulse h at the point h₁ where h rises to H level in Fig. 2 is H level, the switch is judged to be normal and if the output signal j of the push-button switch is L level, the switch is judged to be in trouble (Fig. 3 (F) ).

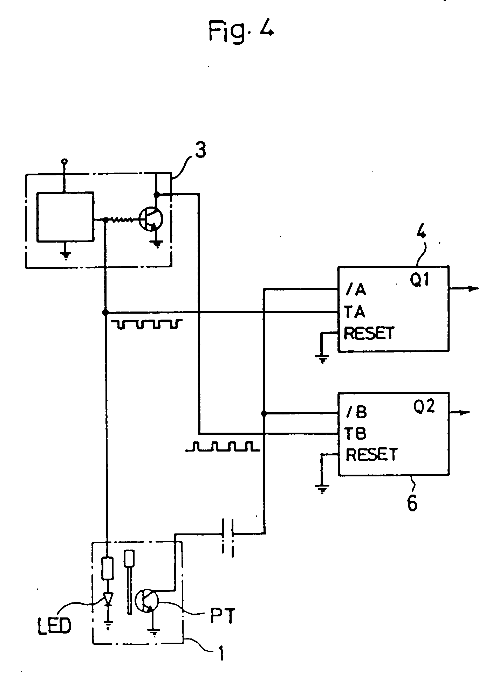

In order to carry out the above discrimination, the discrimination circuit 4 uses a shift register (C-MOS4015B), for example. Its circuit is shown in Fig. 4.

An input terminal 1A of the discrimination circuit (hereinafter referred to as the shift register) is connected to an output terminal of the light receiving element PT. The same pulse as the pulse for the push-button switch is inputted to a clock input terminal TA, whereby the shift register 4 transmits data which are inputted to the input terminal 1A by rising of the electric power source pulse to the output terminal Q1. Therefore, data of the output terminal Q1 is H level in the case of (D), (E) in Fig. 3 and is L level in the case of (F). Thus, the desired discrimination is made possible.

When the push-button switch is ON, output is a pulse signal. It is not preferable to impress such pulse signal to the succeeding logic operation circuit or to the driving circuit 5, such as relay for output. Therefore, it is necessary to convert such pulse signal to a signal which synchronizes (q in Fig. 2) with ON - OFF of the push-button PB.

As is obvious from Fig. 3 (D) and Fig. 4, the light receiving element PT for output works when the push-button PB is ON and the electric power source pulse is on H level. In consideration of the delay of the light receiving element in relation to the light, if the point j₂ of output signal of the push-button switch in relation to the point h₂ at which electric power source pulse to the push-button switch moves from H level (the luminous element emits light) to L level is H level, the push-button switch can be judged as OFF and if it is L level, the push-button switch can be judged as ON.

Therefore, a synchronizing signal conversion circuit 6 which obtains a signal q which synchronizes with ON-OFF of the push-button switch can be composed of a circuit shown in Fig. 4, using a shift register (C-MOS4015B).

An output signal of the push-button switch 1 is inputted to an input terminal 1B of the synchronizing signal conversion circuit 6 (hereinafter referred to as shift register) and pulse which is a reversal of electric power source pulse to be impressed on the push-button switch 1 is inputted to the clock terminal TB, whereby the shift register 6 transmits data inputted to the input terminal 1B to the output terminal Q2 at the point where the electric power source pulse moves from H level to L level. As a result, output of the shift register 6 becomes L level when the push-button PB is ON and becomes H level when the push-button PB is OFF and thus the desired output signal (q in Fig. 2) can be obtained.

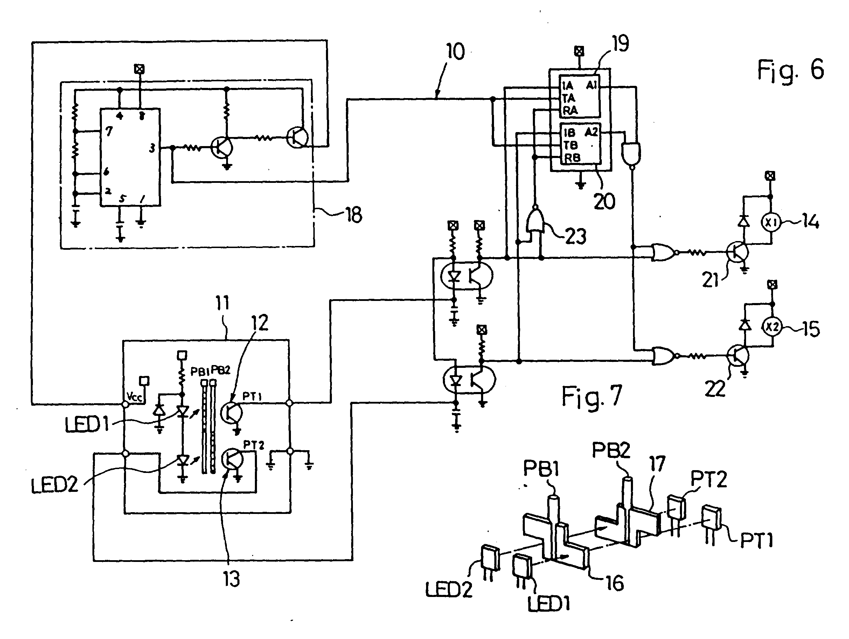

As shown in Fig. 5, if an electric power source pulse of the push-button switch is made the pulse ha with long H level time and very short L level time, output of the push-button switch 1 presents such waveform as ja. Even in the case where this signal is amplified and impressed directly on a coil of the relay, no beat takes place and a contact state can be maintained so long as output ja of push-button switch 1 is used. Thus, the synchronizing signal conversion ciruit 6 for synchronizing with ON-OFF of the push-button can be omitted.

If the above waveform is passed through a CR integration circuit, fluctuation is minimized as shown by jb and if it is further passed through a Schmitt circuit, the waveform almost vanishes and a signal jc which synchronizes with ON-OFF of the push-button can be obtained.

Fig. 6 to Fig. 11 show examples of circuits to which the previously working principle was applied. An operation circuit 10 shown in Fig. 6 and Fig. 7 is provided with two sets of switch unit 12, 13, each of which operates a relay 14 and a relay 15 respectively. While the switch unit 12 comprises a luminous element LED1, a light receiving element PT1 and a push-button PB1 which intervenes between both elements, the switch unit 13 comprises a luminous element LED2, a light receiving element PT2 and a push-button PB2 which is interposed between both elements. The luminous element and the light receiving element are the same as those mentioned above in construction and arrangement of them is shown in Fig. 4. The push-button PB1 is provided with a light shading plate 16. While the push-button PB1 is not pressed (OFF position), this light shading plate 16 intercepts projection from the luminous element LED1 to the light receiving element PT1 but allows projection from the luminous element LED2 to the light receiving element PT2. Kowever, while the pushbutton PB1 is pressed (ON position), projection to the light receiving element PT1 is allowed but projection to the light receiving element PT2 is intercepted. The other push-button PB2 is also provided with a light shading plate 17. This light shading plate 17 selectively intercepts each projection. Thus, while both push-buttons PB1, PB2 are not pressed (OFF position), projection to both light receiving elements is intercepted and even when both push-buttons are pushed by mistake, projection is intercepted and erroneous operation is prevented.

Reference numeral 18 (Fig. 6) shows a pulse power circuit using an IC for timer (555).

The pulse is a pulse ha which has such waveform as shown in Fig. 5 (waveform of long H level time and very short L level time).

Under the above construction, the light receiving element PT1, PT2 is impressed on a discrimination circuit 19, 20 using the shift register mentioned above by selective pressing of the push-button PB1, PB2 and good or bad of each output signal is judged by the shift register. Such output and a push-button signal are inputted and, together with an ON signal from the light receiving element PT1, operate a relay 14 through an amplification circuit 21. Similarly, when an ON signal from the light receiving element PT2 is given, a relay 15 is operated through an amplification circuit 22.

NOR 23 is provided for preventing erroneous operation of a push-button 11. Output which discriminated two push-button signals is inputted to reset terminal RA, RB of the shift register 19, 20 and when ON signals are given from the light receiving elements PT1, PT2 at the same time, output signals from the shift registers 19, 20 are regarded as the same as inferior signals and are interlocked.

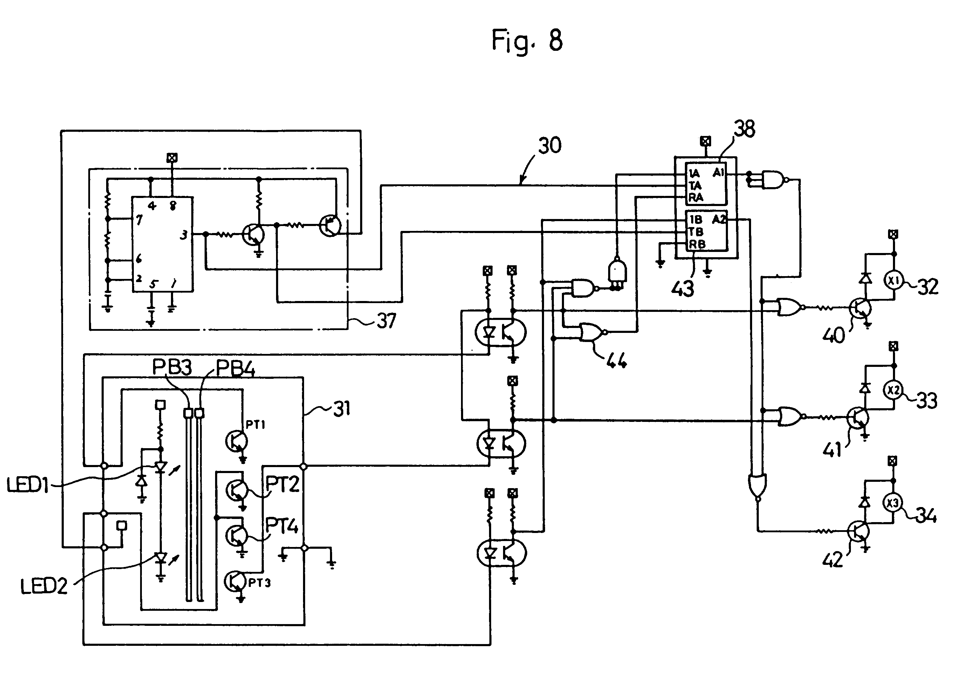

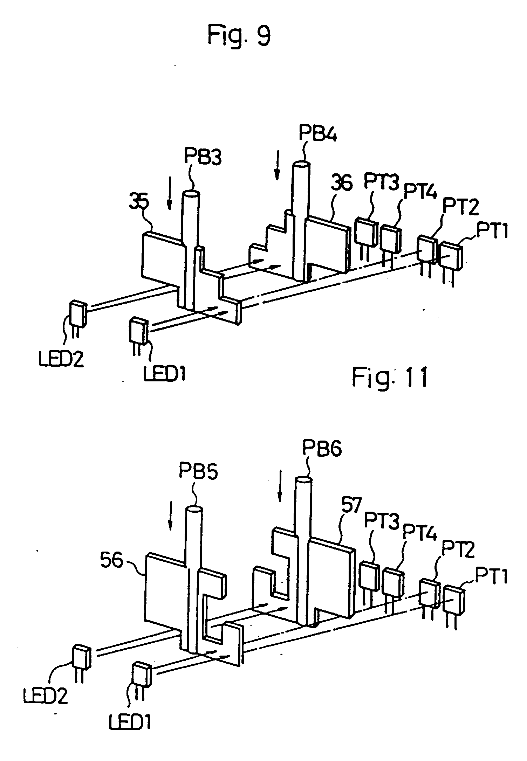

Fig. 8 and Fig. 9 show a non-contact push-button switch 31 of an operation circuit 30 which comprises the luminous element LED1, two light receiving elements PT1, PT2, the luminous element LED2, two light receiving elements PT3, PT4 and two push-buttons PB3, PB4. By two-step shifting of the push-buttons PB3, PB4, relays 32, 33, 34 are operated selectively.

As shown in Fig. 9, push-buttons PB3, PB4 are provided with light shading plates 35, 36. The light shading plate 35 intercepts projection to the light receiving elements PT1, PT2 while the push-button PB3 is not pressed (OFF position), allows projection only to the light receiving element PT1 at the time of first step pressing of the push-button and allows projection to both light receiving elements PT1, PT2 at the time of second step pressing. Projection to the light receiving elements PT3, PT4 is allowed only when the push-button is in OFF position and is intercepted at the time of the first and the second pressing.

On the contrary, the light shading plate 36 fitted to the other push-button PB4 allows selective projection to the light receiving elements PT3, PT4 by similar means.

Reference numeral 37 shows a pulse electric power source and the pulse has a waveform of long H level time and very short L level time.

Output of each light receiving element PT1, PT2, PT3, PT4 is impressed on a discrimination circuit using the shift register mentioned above and an output signal to which such output and signals from each light receiving element PT1, PT2, PT3, PT4 of the push-button switch 31 are inputted is impressed on amplification circuits 40, 41, 42 so as to operate relays 32, 34, 34.

A signal from light receiving elements PT1, PT3 is impressed on NOR 44 and such output is inputted to a reset terminal RA of a discrimination circuit 38 (shift register), whereby ON signals are given from the light receiving elements PT1, PT3 at the same time, the shift register 38 is reset and both signals are interlocked.

This shows the case where output signal of the light receiving elements PT2, PT4 is impressed on a synchronizing signal conversion circuit 43 for converting to signals which synchronize with ON-OFF of the push-buttons PB3, PB4.

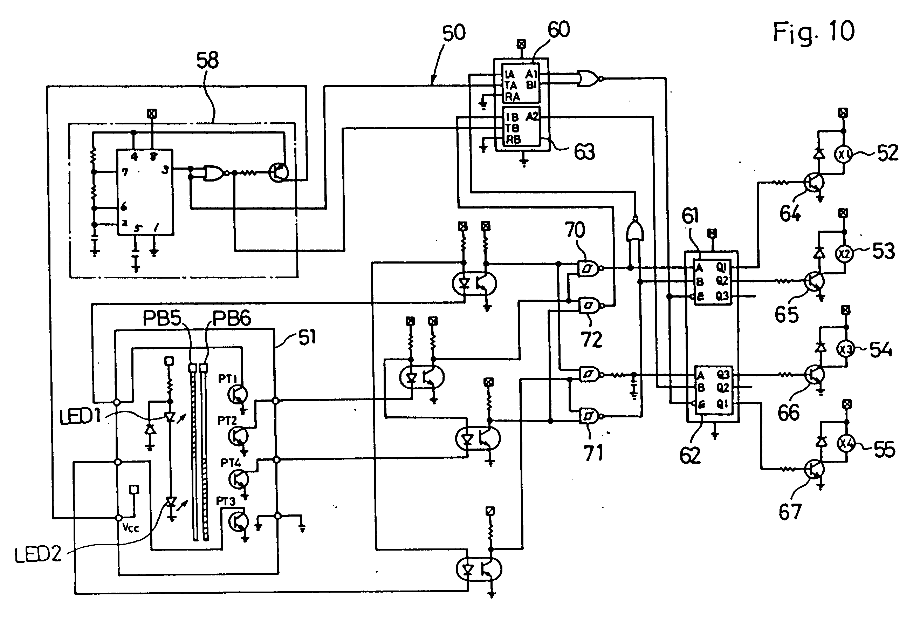

Fig. 10 and Fig. 11 show a non-contact push-button switch 51 of a circuit 50 which comprises the luminous element LED1, two light receiving elements PT1, PT2, the luminous element LED2, two light receiving elements PT3, PT4 and a pair of push-buttons PB5, PB6. By three-step shifting of the push-button, four relays 52, 53, 54, 55 are operated selectively.

As shown in Fig. 11, the push-buttons PB5, PB6 are provided with light shading plates 56, 57. The light shading plate 56 intercepts projection to light receiving elements PT1, PT2 while the push-button PB5 is not pressed (OFF position), allows projection only to the light receiving element PT2 at the time of the first step pressing, allows projection to both light receiving elements PT1, PT2 at the time of the second step pressing and allows projection only to the light receiving element PT1 at the time of the third step pressing.

Projection to the light receiving elements PT3, PT4 is allowed only while the push-button is in OFF position and is intercepted at the time of the first step shifting.

On the contrary, the light shading plate 57 fitted to the push-button PB6 allows selective projection to the light receiving elements PT3, PT4 by similar means.

Reference numeral 58 shows a pulse electric power source circuit using an IC for timer (555). The pulse waveform is such that H level time is long and L level time is very short.

Output of each light receiving element PT1, PT2, PT3, PT4 is inputted to a discrimination circuit 60 through NAND 70, 71. Output signals of the light receiving elements PT2, PT4 are inputted to a synchronizing signal conversion circuit 63 through NAND 72 and is made into output signals which synchronize with ON-OFF of the push-button. Each of such output signals and signals of PT2, PT3, PT4 which passed through NAND are impressed on selective circuits 61, 62.

By using a binary decoder (C-MOS, 4555B), for example, the selective circuits 61, 62 select input 0 of E terminal (output of the discrimination circuit 60 of electronic parts is H level and electronic parts are normal) into output terminal Q1, Q2, Q3 due to input variation (0 or 1) of terminals A, B and output it. When input of E terminal 1 (output of the discrimination circuit 60 of electronic parts is L level and electronic parts are out of order), selective circuits 61, 62 are reset and output is made OFF.

When the push-button PB5 is ON, Q1 of the decoder 61 becomes 1, is amplified by an amplification circuit 64 and drives the relay 52. When the push-button PB6 is ON, Q2 of the decoder 61 becomes 1, is amplified by an amplification circuit 65 and drives the relay 53.

To what step the PB5 and PB6 were operated is judged by the decoder 62. More particularly, at the time of two steps operation, Q3 of the selective circuit 62 becomes 1, is amplified by an amplification circuit 66 and drives the relay 54 and at the time of three steps operation, Q1 of the selective circuit 62 becomes 1, is amplified by an amplification circuit 67 and drives the relay 55. To what step the PB5 and the PB6 were operated can be judged by the relay 52, 53, 54, 55.

Pulse electric power is impressed as a source for operating a non-contact push-button switch and after comparing output from the switch with waveform of the pulse, only when switch output is judged to have a normal pulse waveform, an operation signal is given. Therefore, even if operation output is given from the switch, in spite of the push-button being put in OFF state, owing to trouble of electronic parts constituting a non-contact push-button or for other reason, a signal which means operation is not given from a discrimination circuit and thus unreasonable working of the apparatus does not take place.

Furthermore, the non-contact push-button switch according to the present invention has such construction that it comprises a luminous element, a light receiving and a push-button having a light shading plate interposed between the luminous element and the light receiving element and pulse electric power is impressed on the luminous element. Under this construction, even if a signal line, a power source line of the luminous element and an earth line make cross-contact in a cable between the push-button switch and the control box, it can be judged by a discrimination circuit and a signal which means operation is not given. Thus, safety is ensured.

Fig. 12 to Fig. 19 relate to prevention of mechanical erroneous operation of the push-button.

In the drawings, reference numeral 100 designates a block proper of the push-button switch made of material which is light in weight, durable and insulating, such as synthetic resin. This block proper 100 has at the back thereof two push-button inserting grooves 101 through which two opposing push-buttons 110 are put. A light shading plate inserting groove 102 opens at its both ends into both push-button inserting grooves 101. Each push-button 110 is provided with a light shading plate 111. The size of the light shading plate inserting groove 102 is such that when each push-button 110 is inserted into respective push-button inserting groove 101, each light shading plate 111 is inserted into the light shading plate inserting groove 102, overlapping each other. Provided at the central part of the block proper are element inserting grooves 103, 104 (Fig. 19), in which a light receiving element PT (photo-transistor, CDS cell, photo-diode or the like) and a luminous element LED which are opposite to each other with the light shading inserting groove 102 interposed therebetween are inserted. In the drawing, two element inserting grooves 103, 104 are arranged in parallel so that two sets of a pair of light receiving element and a luminous element are used but it is possible to use only a pair of elements. In the case where a pair of a luminous element and a light receiving element is used, it is used for ON-OFF operation and in case of two-stage or three-stage operation, two of a pair of two light receiving elements are used. The element inserting grooves 103, 104 open only at the bottom surface of the block proper 100 and one element is inserted independently into each groove. A light transmitting hole (not shown in the drawing) is made in the inner wall of this groove so that light of the luminous element reaches the side of the light receiving element.

The outer shape and the size of the push-button 110 are so decided that the push-button 110 does not shake and slides smoothly in the push-button inserting groove 101. The push-button 110 comprises a push-button proper 110A and an auxiliary button 110B, which is put slidably on the upper outer periphery of the push-button proper 110A. A hole is made in lateral direction at the lower part of the push-button proper 110A and in this hole, a spring S and a ball B for action are put. A stepped surface 100A is made at the inside surface of the push-button inserting groove 101 of the block proper 100. This stepped surface, together with the ball B which is pressed by the Spring S, makes it possible to do the push-button pushing down operation by stages (two-stage or three-stage).

An explanation is made below about the push-button proper 110A.

A pushing piece 112 is provided at the top surface of the push-button proper 110A and a spring stop projection 113 is provided at the opposite side of the pushing piece 112. A light shading plate 111 provided at the side of the pushing piece 112 has at its upper end portion a light transmitting window 114 to have the light of the luminous element on the push-button side reach the opposite light receiving element when the push-button is pushed down. A push-down light shading piece 115 which intercepts the light between both elements of the other push-button when the push-button is pushed down is provided at the outer end portion of the light shading plate 111. The light shading plates 111 of the two push-buttons are so located that the light transmitting window 114 of one of the push-buttons corresponds to the push-down light shading piece 115 of the other push-button.

An auxiliary button 110B is mounted on a hollow 116 made at the top surface of the push-button proper 110A. A pushing piece 118 which is put on the pushing piece 112 is provided protrudingly at the upper part of a main part 117 of the auxiliary button 110B and an auxiliary light shading plate 119 is provided at one side end of the main part 117 (Fig. 18 (B) ).

When the pushing piece 112 of the push-button proper 110A is fitted in the pushing piece cavity 118h of the auxiliary button 110B, a spring 110S is interposed between the top surface of the pushing piece 112 and the inner ceiling surface of the hollow 118h. By the action of the spring 110S, the push-button proper 110A and the auxiliary button 110B are forced to separate from each other. The auxiliary light shading plate 119 of the auxiliary button 110B, when the push-button proper works normally, works together with the auxiliary button 110B and when the push-button proper 110A is unreturnable due to damge of a spring 140 (to be described later) for returning or for other reason, the auxiliary button 110B returns in such a manner that it is pushed up by the spring 110S and blocks the light transmitting plate 111.

A small hole 118a is made at the top surface of the pushing piece 118 of the auxiliary button 110B and by thrusting a fine rod R in this hole 118a, the pushing piece 112 of the push-button proper 110A can be pushed down and it is possible to confirm whether the push-button 110 is out of order or not.

A base plate 120 is of such size that it can be fitted in a guide 107 provided around the bottom of the block proper and is provided with a print wiring. The luminous element LED and the light receiving element PT are arranged on the base plate 120. The luminous element LED and the light receiving element PT are opposite to each other and form a pair (one set or two sets of this pair are provided). These elements are inserted in the element inserting grooves 103, 104 of the block proper.

A bottom lid 130 is provided at the bottom of the block proper 100 in such a fashion that it presses and fixes the base plate 120. It is intended for preventing penetration of dust into elements and other parts and is made of insulating material. The bottom lid 130 is provided with support parts 131, 132 which support the spring 140.

In assembling the parts of the above construction, as shown in Fig. 12 two opposite push-buttons 110 are inserted in the push-button inserting grooves 101 in such a fashion that light shading plates 111 overlap each other and the pushing piece 112 projects from the top surface of the block proper. In this case, the pushing piece 112 of the push-button proper 110A is inserted in the pushing piece cavity 118h of the auxiliary button 110B through the medium of the spring 110S.

Then, the base plate 120 with luminous elements and light receiving elements (print wiring) is provided for the back of the block proper. At this time, the light receiving element PT and the luminous element LED are inserted accurately in the element inserting groove 103 and the element inserting groove 104 respectively.

Next, the bottom lid 130 is fitted in and fixed to the guide 107 while the spring 140 is inserted in the spring support part 131, 132. Since elastic force of the spring 140 is stronger than that of the spring 110S, the spring 110S is held in compressed state. The block proper 100 carries a fitting piece 109 having a fitting screw hole 109a to facilitate fitting to a switch case or the like.

When a push-button is pushed, it is pushed down against the force of a spring and the light from a luminous element on the side of that push-button reaches a light receiving element through a light transmitting window of a light shading plate which was pushed down, whereby the light is converted into an electric signal for the desired operation. At this time, the light from a luminous element on the other side is intercepted by a push-down light shading piece of that push-button. Therefore, even if both push-buttons are pushed by mistake, both are put in OFF state and do not work.

When the switch works normally as mentioned above, since elastic force of the spring 140 is stronger than than that of the spring 110S, the spring 110S is in compressed state and therefore the push-button proper 110A and the auxiliary button 110B are united. Under this condition, both the light shading plate 111 and the auxiliary light shading plate 119 are pushed down in a body, with their light transmitting windows coinciding with each other, whereby an optical axis transmits light transmitting windows of the light shading plates and the switch is put in ON state.

There are cases where the push-button is put in pushed down state due to breaking of the spring 14 for restoring the push-button or biting of foreign matters and the push-button does not restore to the original state, even if pushing down force is released. At such time, even if the switch is released from operation, the switch ON state is maintained and it is impossible to put the switch in OFF state. According to the present invention, even when the push-button proper 110A is unrestorable to the original state due to damage of the spring 140 or for other reason, if pushing down force is released, only the auxiliary botton 110B is pushed up by the action of the spring 110S, whereby the auxiliary light shading plate 119 of the auxiliary button 110B coincides with the light transmitting window 114 of the light shading plate 111 of the push-button proper 110A and closes the light transmitting window 114. Thus, the light is shaded by the auxiliary button 110B, even though the push-button proper 110A is not restored and when the push-button pushing down operation is released, switch OFF is ensured irrespective of whether the push-button proper 110A is restored or not and safety can be maintained.

## Claims

1. A push-button switch assembly including: a push-button (110) having a spring (140) for restoring the switch to its initial, non-pushed state and a light shading means (111) with a light transmitting window (114), the push-button (110) being slidably located in a block (107); a light emitting element (LED); and a light receiving element (PT); the light shading means being located between the light emitting element (LED) and the light receiving element (PT) in such a way that when the push-button (110) is pushed, the light of the light emitting element (LED) is cast on the light receiving element (PT), the assembly being characterised by an auxiliary button (110B) which is built into the push-button (110), the auxiliary button (110B) being provided with an associated auxiliary light shading means (119) and an associated spring (110S) for biasing the auxiliary button (110B) away from the push-button (110), the arrangement being such that when the push-button (110) functions normally the light transmitted from the light emitting element (LED) is not inhibited by the auxiliary button (110B) and the associated auxiliary light shading means (119), whereby in the case of a mechanical failure of the spring (140) for restoring the switch to its initial, non-pushed state, the auxiliary button (110B) is moved by the associated spring (110S) away from the push-button (110), which in tum causes the auxiliary light shading means (119) to move between the light emitting element (LED) and the light receiving element (PT) such that an unwanted pushed ON state of the switch due to mechanical failure is avoided.

## Patentansprüche

1. Druckknopf-Schalteranordnung mit einem Druckknopf (110), der eine Feder (140) aufweist, die den Schalter in seinen Ausgangs- bzw. nicht gedrückten Zustand zurückstellt, einer Lichtabschattungsvorrichtung (111) mit einem Licht übertragenden Fenster (114), wobei der Druckknopf (110) in einem Block (107) verschiebbar angeordnet ist, einem Licht emittierenden Element (LED) und einem Licht aufnehmenden Element (PT), wobei die Lichtabschattungsvorrichtung zwischen dem Licht emittierenden Element (LED) und dem Licht aufnehmenden Element (PT) so ange-ordnet ist, daß dann, wenn der Druckknopf (110) gedrückt ist, das Licht des Licht emittierenden Elementes (LED) auf das Licht aufnehmende Element (PT) fällt,
**gekennzeichnet durch** einen Zusatzknopf (110B), der in den Druckknopf (110) eingebaut ist, und der eine zugeordnete Hilfs-Lichtabschattungsvorrichtung (119) und eine zugeordnete Feder (110S) zum Vorspannen des Hilfsknopfes (110B) von dem Druckknopf (110) weg aufweist, wobei die Anordnung so ausgelegt ist, daß dann, wenn der Druckknopf (110) normal arbeitet, das von dem Licht emittierenden Element (LED) übertragene Licht durch den Hilfsknopf (110B) und die zugeordnete Hilfs-Lichtabschattungsvorrichtung (119) nicht behindert wird, und wobei im Falle eines mechanischen Fehlers der Feder (140) zum Rückstellen des Schalters in seinen Ausgangs- bzw. nicht gedrückten Zustand der Hilfsknopf (110B) durch die zugeord-nete Feder (110S) von dem Druckknopf (110) weg bewegt wird, der seinerseits be-wirkt, daß die Zusatz-Lichtabschattungsvorrichtung (119) zwischen dem Licht emittierenden Element (LED) und dem Licht aufnehmenden Element (PT) so bewegt wird, daß ein unerwünschter gedrückter Zustand des Schalters aufgrund eines mechanischen Fehlers vermieden wird.

## Revendications

1. Ensemble formant interrupteur à bouton-poussoir comportant: un bouton-poussoir (110) comprenant un ressort (140) pour rappeler l'interrupteur à son état initial, non poussé, et des moyens (111) d'interception de la lumière présentant une fenêtre (114) de transmission de la lumière, le bouton-poussoir (110) étant placé, avec liberté de coulissement, dans un bloc (107); un élément émetteur de la lumière (LED); et un élément récepteur de la lumière (P); les moyens d'interception de la lumière étant placés entre l'élément émetteur de la lumière (LED) et l'élément récepteur de la lumière (P) de façon telle que, lorsque le bouton-poussoir (110) est poussé, la lumière de l'élément émetteur de la lumière (LED) tombe sur l'élément récepteur de la lumière (PT), l'ensemble étant caractérisé par un bouton auxiliaire (110B) qui est construit dans le bouton-poussoir (110), le bouton auxiliaire (110B) étant équipé de moyens auxiliaires associés (119) d'interception de la lumière et d'un ressort associé (110S) pour contraindre le bouton auxiliaire (110B) à se séparer du bouton poussoir (110), la disposition étant telle que, lorsque le bouton-poussoir (110) fonctionne normalement, la lumière transmise par l'élément émetteur de la lumière (LED) n'est pas interceptée par le bouton auxiliaire (110B) et par les moyens auxiliaires associés (119) d'interception de la lumière, ce par quoi, en cas de défaillance mécanique du ressort (140) prévu pour rappeler l'interrupteur à son état initial, non poussé, le bouton auxiliaire (110B) est amené, par le ressort associé (110S), à se préparer d'avec le bouton-poussoir (110), ce qui, à son tour, fait que les moyens auxiliaires (119) d'interception de la lumière se déplacent entre l'élément émetteur de la lumière (LED) et l'élément récepteur de la lumière (PT) de façon telle qu'un état poussé, en position de circuit fermé, non désiré, de l'interrupteur dû à une défaillance mécanique est évité.
